# Europäisches Patentamt
## European Patent Office
## Office européen des brevets

(19)

(11) Publication number: **0 068 167**
**B1**

(12) **EUROPEAN PATENT SPECIFICATION**

(45) Date of publication of patent specification: **07.05.86**

(51) Int. Cl.⁴: **H 01 B 1/02, H 05 B 41/34**

(21) Application number: **82104857.6**

(22) Date of filing: **03.06.82**

(54) **Conductive composition comprising copper, and flash bar produced therewith.**

(30) Priority: **03.06.81 US 269865**

(43) Date of publication of application:
**05.01.83 Bulletin 83/01**

(45) Publication of the grant of the patent:
**07.05.86 Bulletin 86/19**

(84) Designated Contracting States:
**BE DE FR GB IT LU NL**

(56) References cited:
**US-A-3 988 647
US-A-4 070 518
US-A-4 072 771
US-A-4 172 919**

(73) Proprietor: **E.I. DU PONT DE NEMOURS AND COMPANY**
**1007 Market Street**
**Wilmington Delaware 19898 (US)**

(72) Inventor: **Mc Cormick, Cornelius Joseph**
**R.D.2, Box 414**
**Hockessin Delaware 19707 (US)**
Inventor: **Moneta, Robert John**
**18 Winding Lane**
**Wilmington Delaware 19809 (US)**

(74) Representative: **von Kreisler, Alek, Dipl.-Chem. et al**
**Deichmannhaus am Hauptbahnhof**
**D-5000 Köln 1 (DE)**

## Description

Background of the invention

This invention relates to thick film copper conductor compositions and, in particular, to a thick film copper conductor composition adapted for use with porcelain enamel steel and fireable at 550°C to 700°C.

Porcelain enamel steel is a material containing a steel core having a layer of porcelain material adhered thereto. The porcelain layer is electrically nonconducting. Porcelain enamel steel has a variety of uses and is commonly used as the substrate in flash bars for cameras.

In order to provide electrically conductive paths on the nonconducting surface of porcelain enamel steel it is believed advantageous to utilize a thick film conductor composition which, when applied to a porcelain surface using thick film techniques and fired, results in formation of conductive pathways. It is believed desirable that any thick film composition for use with porcelain enamel steel contain a nonnoble metal, such as copper, primarily because of cost considerations. In addition, since the firing of the thick film conductor may impose thermal stresses upon the porcelain enamel steel substrate and because the substrate softens at approximately 650°C, it is believed advantageous that the active phase of copper particles in the thick film composition sinter at a relatively low temperature. In addition, the composition must exhibit acceptable "green strength" after application onto the substrate but prior to firing and good adhesion after firing. Green strength is the term used to denote the adhesive and cohesive strength of a dried, unfired, thick film composition. Green strength is important to facilitate processing.

US—A—4 070 518 (1) is directed to thick film conductor compositions comprising 85 to 97 wt.%. Cu powder and 15 to 3 wt.% of a quite specific lead borosilicate glass dispersed in an unspecified organic vehicle. The copper of the reference is essentially free from oxygen. Moreover, the claimed glasses of the reference are fired at 700 to 1000°C. On the other hand, the present composition has a low (550 to 700°C) sintering temperature. Though methacrylic resins are mentioned among many possible vehicle components, they are not used in any specific Example.

US—A—4 072 771 (2) is directed to a thick film conductor composition comprising surface-oxidized copper particles and a glass frit dispersed in an organic medium. In the reference examples the compositions are fired at 875°C whereas the present compositions are fired at only 600°C.

US—A—4 172 919 (3) discloses compositions comprising 86 to 97% Cu, 1 to 7% $CUO_x$ and 1 to 7% of a high $Bi_2O_3$ glass dispersed in an organic medium. The firing range of the compositions is 875 to 925°C. Methacrylate polymer dissolved in terpineol is stated to have been used as film vehicle in the examples but there is no specific teaching as to the quantity of methacrylate.

The instant invention relates to a composition suitable for forming thick film conductors by firing consisting apart from impurities of an admixture of finely divided particles of

(A) 65 to 80 parts by weight copper metal powder,

(B) 1.5 to 6 parts by weight copper oxide and

(C) 3 to 8 parts by weight glass frit which sinters at 550 to 700°C dispersed in an organic vehicle comprising 20 to 40% by weight methacrylate resin dissolved in a volatile solvent, and

(D) optionally plasticizers in an amount up to 6 parts by weight and/or wetting agents in an amount up to 0.1 parts by weight of the composition, whereby all parts are given by total weight of the solids in the composition.

In another aspect the invention relates to a method of making a flash bar comprising the steps of:

(A) applying the compositions mentioned above to a porcelain enamel steel substrate; and

(b) firing the composition at a temperature in the range of 550—700°C in a nitrogen atmosphere to sinter the glass and metal.

The instant invention relates to a thick film copper conductor composition especially adapted for use in the fabrication of flash bar elements. Thick film techniques are contrasted with thin film techniques which involve deposition of particles by evaporation or sputtering. Thick film techniques are discussed in *Handbook of Materials and Processing for Electronics*, C.A. Harper, Editor, McGraw-Hill, N.Y., 1970, Chapter 12.

The active phase of the composition is copper powder. The copper powder is 98 to 99% pure copper, with the remainder being minor amounts of impurities such as tin, chromium, iron, nickel, silicon, calcium, lead, silver, aluminum, manganese, bismuth, magnesium and titanium and oxides thereof. Particle size of the powder used in the composition of this invention lies in the range from 1/2 to 10 µm. The thick film conductor composition of the instant invention has, based on the total weight of the solids in the composition, 65 to 80 parts copper powder. Preferably, the copper powder lies in the range from 73 to 78 parts by total weight of the solids in the composition.

The thick film conductor composition also includes from 1.5 to 6 parts and preferably from 4 to 5 parts, by total weight of the solids in the composition, cupric oxide. Copper oxide increases the adhesion strength of the fired composition to the substrate and also aids decomposition of the vehicle. The copper oxide may be added in the form of a particulate powder having a particle size in the range of 1 to 10 µm. However, if more convenient, copper oxide may be added in the form of a paste that includes 82% (by weight of the added paste) cupric oxide and 18% of an organic vehicle system compatible with the primary vehicle system discussed herein.

The thick film copper composition also contains from 3 to 8 parts, and preferably from 4 to 7 parts, and most preferably from 5.7 parts to 6.4 parts, by total weight of the solids in the composition, glass. Since, as discussed herein, the composition in the instant invention sinters at a relatively low temperature (550—700°C) the glass frit utilized must be a low melting temperature frit. Any low melting temperature glass frit may be used. The preferred glass frit contains 68.4% PbO, 13% $B_2O_3$, 9.3% each silicon dioxide $SiO_2$ and cadmium oxide CdO, where the percentages are by total weight of the glass frit. Glass frit is ball milled to a fine particle size having a surface area of approximately 5 $m^2.g^{-1}$. Alternatively, a frit having 78.1% PbO, 12.4% $B_2O_3$, 5.4% $SiO_2$ and 4.1% $Al_2O_3$ or one which contains 60.2% CdO, 15.9% $B_2O_3$, 14.5% $Si_2O_3$, 7.1 $Na_2O$ and 2.3% $Al_2O_3$, (where the percentages are by total weight of the frit) may be used with the methacrylate vehicle system.

Copper oxide is used in conjunction with an organic vehicle based on a methacrylate polymer system. Methacrylate more cleanly decomposes at a low temperature (200—350°C) in a low oxygen content enviroment. The most preferred vehicle is based on poly(ethylmethacrylate) while other polymers, namely poly(methylmethacrylate) and poly(isobutylmethacrylate) may also be utilized. The vehicle will preferably be present in the composition in the range from 6.5 to 21 parts by total weight of the composition. The polymer is dissolved in a volatile solvent. The preferred solvent is diethylene glycol monobutylether acetate but diethyleneglycol dibutyl ether and dibutyl phthalate (and mixtures thereof with diethylene glycol monobutylether acetate) may also be used. By weight of the vehicle, the polymer is 20—40%, with the remainder solvent. Preferably, the polymer is 25—40% by weight of the vehicle. The vehicle can contain volatile liquids to promote fast setting after application to the substrate.

The composition may include a plasticizer, such a dibutylphthalate, which is preferred. If used, the plasticizer is up 0 to 6 parts by total weight of the composition. This material is volatilized from the composition in the range 200—350°C.

A wetting agent, such as tridecylphosphate may be added to the composition if desired. The wetting agent, if used, lies in the range up to 0.1 parts by total weight of the composition.

The viscosity of the composition may be modified to the desired rheology by appropriately adjusting the relative proportions of the copper to copper oxide and the resin to the solvent and plasticizer/wetting agent (if used).

Example 1

The first example of the invention is a relatively large batch formulation using an ethylmethacrylate polymer vehicle in a diethyleneglycolmonobutylether acetate solvent. A first paste component was prepared by hand blending 142.9 g of copper powder of the purity discussed above having particle size in the range from 1/2 to 10 μm with 12.3 g of the preferred glass frit as discussed above, and 16.0 g of an organic vehicle. The vehicle was composed of 32 parts ethylmethacrylate polymer and 68 parts diethylene glycol monobutyl ether acetate solvent. 8.0 g of dibutyl phthalate was added to adjust rheological properties of this component.

12.3 g of a second paste component containing 84.3 parts finely ground (less than 20 μm) cupric oxide and a vehicle composed of 14.4 parts of diethylene glycol dibutyl ether, 4.1 parts of terpineol and 1.2 parts ethylcellulose.

The two paste components were blended in two passes on a roll mill initially without roll pressure. The pressure was increased in two subsequent passes to 350 and 700 KPa (50 and 100 psig), respectively.

The resultant paste composition was screened through a 75 μm stainless steel sieve to remove any large flakes formed in the milling operation. The resultant paste was screen printed through a 53 μm (325 mesh) stainless steel screen onto the surface of a porcelain enamel steel substrate. The printed paste exhibited acceptable green strength as tested by dropping the printed substrate face down from a height of 1,2 m (four feet) onto a plastic tile floor. As noted earlier, green strength is the term used to denote the adhesive and cohesive strength of a dried, unfired thick film composition. The printed paste was fired in nitrogen at 600°C for 6 minutes. The fired flash bar element was tested for peel adhesion strength (approximately 17.8 N on 2.03 mm×2.03 mm (80 by 80 mil) pads and for electrical resistance (less than five mΩ per square per 25.4 μm (mil)) before and after fifty camera insertions. Adhesion was tested as follows. Wire leads were attached to the fired conductor pads by placing a 0.9 mm in diameter (20-gauge) pretinned copper wire across three of the fired pads and then dipping them in a solder pot (60/40 Sn/Pb) at a temperature between 220°C and 250°C. Bond strengths were measured by pulling the soldered leads at 90° to the substrate with an Instron® tester. Several pads were pulled to obtain a representative bond strength. The fired flash bar elements exhibited acceptable fired adhesion (greater than 13.3 N and electrical properties (less than 5 mΩ per square resistance).

Example 2

The second example of the invention was a larger batch size having slight compositional variations from Example 1. A vehicle system of 59.5 g of 32 parts ethylmethacrylate polymer and 68 parts diethyleneglycol monobutyl ether solvent, 35.8 g dibutylphthalate, 0.5 g tridecyl phosphate and 39.7 g of the cupric oxide paste component described in Example 1 were mixed. To this mixture 500 g copper powder in the range from 1/2 to 10 μm and 39.7 g of the preferred glass frit (68.4% PbO, 13.0% $B_2O_3$, 9.3% $SiO_2$ and 9.3% CdO, by weight of the frit) were hand blended to wet the solids.

The resultant paste was further blended on a roll mill with one pass without roll pressure and two passes at 33 KPa (50 psig). The resultant paste was screened dried, tested as described in Example 1, and exhibited acceptable green strength. The paste was screen printed and fired as described in Example 1 to produce a flash bar element which exhibited acceptable adhesion and electrical properties as described in Example 1.

Example 3

The third example of the invention was a small batch size and included a wetting agent. 3.75 g of copper powder (1/2 to 10 µm) and 0.3 g of the glass frit of Example 2 and 0.23 g copper oxide powder were hand blended into a mixture of 0.43 g of the vehicle system of Example 2 and 0.29 g dibutylphthalate/tridecylphosphate mixture where the tridecylphosphate was 0.1% of the mixture. The paste formed was further blended on an automatic mulling machine. The resultant paste was printed, and tested as described in Example 1 and exhibited acceptable green strength. The composition was screen printed and fired as in Example 1. The resulting flash bar element exhibited acceptable adhesion and electrical properties as described in Example 1.

Example 4

The fourth example of the invention used a methylmethacrylate polymer vehicle. A mixture of 3.9 g copper powder of the purity discussed above and 0.3 g of the preferred cadmium oxide glass frit were hand blended with a mixture of 0.13 g poly(methylmethacrylate) dissolved in 0.27 g of diethyleneglycol monobutylether acetate, 0.2 g dibutyl phthalate and 0.2 g of copper oxide paste of the type described in Example 1. The mixture was further blended on an automatic mulling machine until uniformly dispersed. The resultant paste was printed and tested as described in Example 1 with electrical and mechanical properties described in Example 1.

Example 5

This example of the invention used isobutylmethacrylate polymer vehicle. A mixture of 3.9 g copper powder of the purity discussed above and 0.3 g of the preferred cadmium oxide glass frit were hand blended with a mixture of 0.18 g poly(isobutylmethacrylate) dissolved in 0.42 g of diethyleneglycol monobutylether acetate, 0.2 g of dibutyl phthalate and 0.2 g of copper oxide paste of the type described in Example 1. The mixture was further blended on an automatic mulling machine until uniformly dispersed. The resultant paste was printed and tested as described in Example 1 with electrical and mechanical properties as described in Example 1.

Example 6

The sixth example of the invention used an ethylmethacrylate polymer in a solvent different from that used in Example 1. A mixture of 3.9 g copper powder of the purity discussed above and 0.3 g of the preferred cadmium oxide glass frit were hand blended with a mixture of 0.12 g poly(ethylmethacrylate) dissolved in 0.48 g of terpineol, 0.01 g tridecyl phosphate and 0.2 g of copper oxide paste of the type described in Example 1. The mixture was further blended on an automatic mulling machine until uniformly dispersed. The resultant paste was printed and tested as described in Example 1 with electrical and mechanical properties as described in Example 1.

Claims

1. A composition suitable for forming thick film conductors by firing consisting apart from impurities of an admixture of finely divided particles of

(A) 65 to 80 parts by weight copper metal powder,

(B) 1.5 to 6 parts by weight copper oxide and

(C) 3 to 8 parts by weight glass frit which sinters at 550 to 700°C dispersed in an organic vehicle comprising 20 to 40% by weight methacrylate resin dissolved in a volatile solvent, and

(D) optionally plasticizers in an amount up to 6 parts by weight and/or wetting agents in an amount up to 0.1 parts by weight of the composition, whereby all parts are given by total weight of the solids in the composition.

2. The composition of claim 1 wherein the copper powder lies in the range from 73 to 78 parts by total weight of the solids in the composition, and wherein the copper oxide is cupric oxide.

3. The composition of claim 2 wherein the copper oxide lies in the range from 4 to 5 parts by total weight of the solids in the composition.

4. The composition of claims 2 or 3 wherein the resin is selected from poly(ethylmethacrylate), poly(methylmethacrylate), and poly(isobutylmethacrylate).

5. The composition of claims 2 to 4, wherein the solvent is diethylene glycol monobutyl ether acetate.

6. The compositions of claims 1 to 5 wherein the glass contains 68.4% PbO, 13% $B_2O_3$, 9.3% $SiO_2$ and 9.3% Cd=, by weight of the glass.

7. A method of making a flash bar comprising the steps of:

(A) applying the compositions of claims 1 to 6 to a porcelain enamel steel substrate; and

(B) firing the composition at a temperature in the range of 550—700°C in a nitrogen atmosphere to sinter the glass and metal.

Patentansprüche

1. Zusammensetzung, die zur Herstellung von Dickfilm-Leitern durch Brennen geeignet ist, bestehend aus, abgesehen von Verunreinigungen, einer Mischung feiner Teilchen von

(A) 65 bis 80 Gew.-Teilen Kupfer-Metall-Pulver,

(B) 1,5 bis 6 Gew.-Teilen Kupferoxid und

(C) 3 bis 8 Gew.-Teilen Glasfritte, die bei 550°C bis 700°C sintert, dispergiert in einem organischen Lösemittel, das 20 bis 40 Gew.-% Methacrylat-Harz, gelöst in einem flüchtigen Lösungsmittel, enthält, und

(D) gegebenenfalls Weichmacher in einer Menge bis zu 6 Gew.-Teilen und/oder Netzmitteln in einer Menge bis zu 0,1 Gew.-Teilen der Zusammensetzung, wobei alle Teile sich auf das Gesamtgewicht der Feststoffe in der Zusammensetzung beziehen.

2. Zusammensetzung nach Anspruch 1, dadurch gekennzeichnet, daß die Menge des Kupfer-Pulvers in dem Bereich von 73 bis 78 Teilen des Gesamtgewichts der Feststoffe in der Zusammensetzung liegt und das Kupferoxid Kupfer (II)-oxid ist.

3. Zusammensetzung nach Anspruch 2, dadurch gekennzeichnet, daß die Menge des Kupferoxids in dem Bereich von 4 bis 5 Teilen des Gesamtgewichts der Feststoffe in der Zusammensetzung liegt.

4. Zusammensetzung nach Ansprüchen 2 oder 3, dadurch gekennzeichnet, daß das Harz aus Poly(ethylmethacrylat), Poly(methylmethacrylat) und Poly(isobutylmethacrylat) ausgewählt ist.

5. Zusammensetzung nach Ansprüchen 2 bis 4, dadurch genkennzeichnet, daß das Lösungsmittel Diethylenglycolmonobutylether-acetat ist.

6. Zusammensetzung nach Ansprüchen 1 bis 5, dadurch gekennzeichnet, daß das Glases 68,4% PbO, 13% $B_2O_3$, 9,3% $SiO_2$ und 9,3% CdO, bezogen auf das Gewicht des Glases, enthält.

7. Verfahren zur Herstellung einer Blitzleiste mit den Schritten

(A) Auftragen der Zusammensetzungen nach Ansprüchen 1 bis auf ein Porzellan-Emaille-Stahl-Substrat und

(B) Brennen der Zusammensetzung bei einer Temperatur in dem Bereich von 550°C bis 700°C in einer Stickstoffatmosphäre zur Sinerung des Glases und des Metalls.

**Revendications**

1. Une composition convenant pour former par cuisson des conducteurs en couche épaisse qui consiste, hormis les impuretés, en un mélange de particules finement divisées de

(A) 65 à 80 parties en poids de poudre de cuivre métallique,

(B) 1,5 à 6 parties en poids d'oxyde de cuivre, et

(C) 3 à 8 parties en poids de fritte de verre que se fritte à 550—700°C, dispersé dans un véhicule organique comprenant 20 à 40% en poids de résine de méthacrylate dissoute dans un solvant volatil, et

(D) facultativement des plastifiants en une quantité ne dépassant pas 6 parties en poids et/ou des agents mouillants en une quantité ne dépassant pas 0,1 partie en poids de la composition, toutes les parties étant exprimées par rapport au poids total des matières solides de la composition.

2. La composition de la revendication 1, dans laquelle la poudre de cuivre se situe dans l'intervalle de 73 à 78 parties du poids total des matières solides de la composition, et dans laquelle l'oxyde de cuivre est l'oxyde cuivrique.

3. La composition de la revendication 2, dans laquelle l'oxyde de cuivre se situe dans l'intervalle de 4 à 5 parties du poids total des matières solides de la composition.

4. La composition de la revendication 2 ou 3, dans laquelle la résine est choisie parmi le poly(méthacrylate d'éthyle), le poly(méthacrylate de méthyle) et le poly(méthacrylate d'isobutyle).

5. La composition des revendications 2 à 4, dans laquelle le solvant est l'acétate d'éther monobutylique du diéthylène-glycol.

6. Les compositions des revendications 1 à 5, dans lesquelles le verre contient 68,4% de PbO, 13% de $B_2O_3$, 9,3% de $SiO_2$ et 9.3% de CdO, par rapport au poids du verre.

7. Un procédé de fabrication d'une rampe-flash comprenant les étapes suivantes:

(A) application des compositions des revendications 1 à 6 à un substrat d'acier émaillé à la porcelaine; et

(B) cuisson de la composition à une température comprise dans la plage de 550—700°C sous atmosphère d'azote de façon à fritter le verre et le métal.